# EUROPEAN PATENT APPLICATION

(11) **EP 4 722 755 A1**
(43) Date of publication of application: **08.04.2026**
(21) Application number: 25189776.5
(22) Date of filing: 16.07.2025
(51) Int. Cl.: G01S 7/481, G01S 17/42, G01S 17/894

(54) **DISTANCE MEASURING APPARATUS**

(30) Priority: 04.10.2024 JP 2024174845; 14.03.2025 JP 2025041933
(71) Applicant: FUJIFILM Business Innovation Corp., Minato-ku Tokyo (JP)
(72) Inventor: HAYAKAWA, Junichiro, Ebina-shi, Kanagawa (JP); TAKEYAMA, Kei, Ebina-shi, Kanagawa (JP); YAMAMOTO, Yoshihiro, Yokohama-shi, Kanagawa (JP)
(74) Representative: Becker Kurig & Partner Patentanwälte mbB

(57) **Abstract**

A distance measuring apparatus includes a light source unit in which plural light sources each including plural divided light emitting sections are disposed, and the plural light sources irradiate different regions, respectively, a light receiving unit that receives reflected light of light emitted from the plural light sources to a detection target object, and a distance measuring unit that performs distance measuring of the detection target object in accordance with a waveform of the light received by the light receiving unit, in which the plural light sources of the light source unit are disposed with the light receiving unit interposed among the plural light sources.

## Description

### BACKGROUND OF THE INVENTION

### (i) Field of the Invention

The present invention relates to a distance measuring apparatus.

### (ii) Description of Related Art

JP2021-153135A discloses a light emitting apparatus including a plurality of driving units, a plurality of laser element arrays, and connection wiring. The plurality of laser element arrays are connected to the plurality of driving units, respectively. The connection wiring connects terminals connected to the driving units of the laser element arrays among the plurality of laser element arrays.

JP2023-113029A discloses a distance measuring apparatus including a light emitting unit, a light receiving unit, a shaping unit, a measuring unit, and a correction unit. The light emitting unit includes a plurality of light emitting elements and can be independently driven in a plurality of regions. The light receiving unit includes a plurality of light receiving elements that receive reflected light of light emitted from the light emitting unit to a target object. The shaping unit generates an overlapping portion in which the reception of the reflected light overlaps between adjacent regions on the light receiving unit. The measuring unit measures a distance to the target object from a difference between a waveform of the light received by the light receiving unit and a waveform of the light emitting unit. The correction unit corrects a difference in the distance between the adjacent regions of the reflected light using a distance measuring value in the overlapping portion measured by the measuring unit.

### SUMMARY OF THE INVENTION

Generally, in a case where a plurality of light sources are disposed, regions irradiated by the light sources can be brought closer to each other by disposing the plurality of light sources closer to each other. Thus, the plurality of light sources are collectively disposed closer to each other. However, in a case where a light source including a plurality of divided light emitting sections is used, a difference in overlapping between each light emitting section and a light receiving region is noticeable. Accordingly, an unnecessary irradiation time may occur.

An object of the present invention is to provide a distance measuring apparatus that can reduce a decrease in the number of divided light emitting sections within an angle of view of a light receiving unit compared to a case where a plurality of light sources each including a plurality of divided light emitting sections are collectively disposed on only one side of the light receiving unit.

According to a first aspect of the present disclosure, there is provided a distance measuring apparatus including a light source unit in which plural light sources each including plural divided light emitting sections are disposed, and the plural light sources irradiate different regions, respectively, a light receiving unit that receives reflected light of light emitted from the plural light sources to a detection target object, and a distance measuring unit that performs distance measuring of the detection target object in accordance with a waveform of the light received by the light receiving unit, in which the plural light sources of the light source unit are disposed with the light receiving unit interposed among the plural light sources.

According to a second aspect of the present disclosure, in the distance measuring apparatus according to the first aspect, a centroid of the light source unit may coincide with a centroid of the light receiving unit.

According to a third aspect of the present disclosure, in the distance measuring apparatus according to the first aspect or the second aspect, the disposition of the plurality of light sources of the light source unit may be disposition in which a sum total of distances between the light sources and the light receiving unit is smaller than a sum total of distances among the plurality of light sources.

According to a fourth aspect of the present disclosure, in the distance measuring apparatus according to any one of the first aspect to the third aspect, the number of light sources included in the light source unit may be four or more, and the light sources may be disposed with the light receiving unit interposed among the light sources in a first direction and be disposed with the light receiving unit not interposed among the light sources in a second direction orthogonal to the first direction.

According to a fifth aspect of the present disclosure, in the distance measuring apparatus according to any one of the first aspect to the fourth aspect, the light emitting sections may have rectangular shapes, and the light sources may be disposed such that long sides of the light emitting sections face each other with the light receiving section interposed among the light emitting sections, and an irradiation region of the light source on one side and an irradiation region of the light source on the other side with respect to the light receiving unit may overlap with each other on a center portion side of the light receiving unit.

According to a sixth aspect of the present disclosure, in the distance measuring apparatus according to the fifth aspect, one of the light emitting sections may be turned off in a part in which the light emitting sections overlap with each other in the irradiation region.

According to a seventh aspect of the present disclosure, in the distance measuring apparatus according to any one of the first aspect to the fourth aspect, the light emitting sections may have rectangular shapes and be disposed such that short sides of the light emitting sections face each other with the light receiving unit interposed among the light emitting sections, and at least a part of all of the light emitting sections may fall within a light receiving region of the light receiving unit.

According to an eighth aspect of the present disclosure, in the distance measuring apparatus according to any one of the first aspect to the seventh aspect, the plurality of light sources may be evenly disposed on both sides of the light receiving unit.

According to a ninth aspect of the present disclosure, in the distance measuring apparatus according to any one of the first aspect to the fourth aspect, the light receiving unit may have a rectangular shape, and the plurality of the light sources may be disposed on both sides of the light receiving unit at a distance corresponding to a short side of the light receiving unit.

According to a tenth aspect of the present disclosure, in the distance measuring apparatus according to the ninth aspect, the plurality of light sources may be disposed along a long side of the light receiving unit.

According to an eleventh aspect of the present disclosure, in the distance measuring apparatus according to any one of the first aspect to the fourth aspect, the light receiving unit may have a rectangular shape, the plurality of light sources may be disposed on both sides of the light receiving unit at a distance corresponding to a long side of the light receiving unit, and the plurality of light sources may be disposed along a short side of the light receiving unit.

According to the distance measuring apparatus according to the first aspect of the present disclosure, a decrease in the number of divided light emitting sections within an angle of view of the light receiving unit can be reduced compared to a case where a plurality of light sources each including a plurality of divided light emitting sections are collectively disposed on only one side of a light receiving unit.

According to the distance measuring apparatus according to the second aspect of the present disclosure, a decrease in the number of divided light emitting sections within the angle of view of the light receiving unit can be reduced compared to a case where a centroid of a light source unit is separated from a centroid of a light receiving unit.

According to the distance measuring apparatus according to the third aspect of the present disclosure, a decrease in the number of divided light emitting sections within the angle of view of the light receiving unit can be reduced compared to a case where disposition of a plurality of light sources is disposition in which a sum total of distances between the light sources and a light receiving unit is larger than a sum total of distances among the plurality of light sources.

According to the distance measuring apparatus according to the fourth aspect of the present disclosure, a decrease in the number of divided light emitting sections within the angle of view of the light receiving unit can be reduced in a configuration in which light sources are disposed with a light receiving unit interposed among the light sources in the first direction and are disposed with the light receiving unit not interposed among the light sources in the second direction orthogonal to the first direction.

According to the distance measuring apparatus according to the fifth aspect of the present disclosure, occurrence of an irradiation gap among the plurality of light sources in a center portion of the light receiving unit can be reduced compared to a case where light emitting sections closer to a light receiving unit do not overlap with each other in an irradiation region.

According to the distance measuring apparatus according to the sixth aspect of the present disclosure, power consumption can be reduced compared to a case where both of light emitting sections emit light in a part in which the light emitting sections overlap with each other in an irradiation region.

According to the distance measuring apparatus according to the seventh aspect of the present disclosure, a decrease in the number of divided light emitting sections within the angle of view of the light receiving unit can be reduced compared to a case where a part of light emitting sections does not fall within a light receiving region of a light receiving unit.

According to the distance measuring apparatus according to the eighth aspect of the present disclosure, a decrease in the number of divided light emitting sections within the angle of view of the light receiving unit can be reduced compared to a case where a plurality of light sources are disposed at different positions on both sides of a light receiving unit.

According to the distance measuring apparatus according to the ninth aspect of the present disclosure, the occurrence of the irradiation gap among the plurality of light sources in the center portion of the light receiving unit can be reduced compared to a case where a plurality of light sources are disposed on both sides of a light receiving unit at a distance corresponding to a long side of the light receiving unit.

According to the distance measuring apparatus according to the tenth aspect of the present disclosure, a decrease in the number of divided light emitting sections within the angle of view of the light receiving unit can be reduced compared to a case where one light source is disposed along a long side of a light receiving unit.

According to the distance measuring apparatus according to the eleventh aspect of the present disclosure, a decrease in the number of divided light emitting sections within the angle of view of the light receiving unit can be reduced compared to a case where one light source is disposed along a short side of a light receiving unit.

### BRIEF DESCRIPTION OF THE DRAWINGS

Exemplary embodiment(s) of the present invention will be described in detail based on the following figures, wherein:
Fig. 1 is a schematic configuration diagram illustrating a distance measuring apparatus according to a first exemplary embodiment;
Fig. 2 is a block diagram illustrating a hardware configuration of the distance measuring apparatus according to the first exemplary embodiment;
Fig. 3A is a configuration diagram illustrating an optical device of the distance measuring apparatus according to the first exemplary embodiment, and Fig. 3B is a diagram illustrating a situation on a projection surface of the distance measuring apparatus according to the first exemplary embodiment;
Fig. 4A is a diagram illustrating a first example of a rectangle of a light source, and Fig. 4B is a diagram illustrating a second example of the rectangle of the light source;
Fig. 5A is a diagram illustrating a centroid of the light source, and Fig. 5B is a diagram illustrating a centroid of a light source unit including four light sources and a centroid of a light receiving unit;
Fig. 6A is a configuration diagram illustrating an optical device of a distance measuring apparatus according to a second exemplary embodiment, and Fig. 6B is a diagram illustrating a situation on a projection surface of the distance measuring apparatus according to the second exemplary embodiment;
Fig. 7A is a configuration diagram illustrating an optical device of a distance measuring apparatus according to a third exemplary embodiment, and Fig. 7B is a diagram illustrating a situation on a projection surface of the distance measuring apparatus according to the third exemplary embodiment;
Fig. 8A is a configuration diagram illustrating an optical device of a distance measuring apparatus according to a fourth exemplary embodiment, and Fig. 8B is a diagram illustrating a situation on a projection surface of the distance measuring apparatus according to the fourth exemplary embodiment;
Fig. 9A is a configuration diagram illustrating an optical device of a distance measuring apparatus according to a fifth exemplary embodiment, and Fig. 9B is a diagram illustrating a situation on a projection surface of the distance measuring apparatus according to the fifth exemplary embodiment;
Fig. 10A is a configuration diagram illustrating an optical device of a distance measuring apparatus according to a sixth exemplary embodiment, and Fig. 10B is a diagram illustrating a situation on a projection surface of the distance measuring apparatus according to the sixth exemplary embodiment;
Fig. 11A is a perspective view illustrating a situation on a projection surface of a distance measuring apparatus of a first comparative example, and Fig. 11B is a side view illustrating an angle of view of a light source and an angle of view of a light receiving unit of the distance measuring apparatus of the first comparative example; and
Fig. 12A is a configuration diagram illustrating an optical device of a distance measuring apparatus of a second comparative example, and Fig. 12B is a diagram illustrating a situation on a projection surface of the distance measuring apparatus of the second comparative example.

### DETAILED DESCRIPTION OF THE INVENTION

Hereinafter, an example of an exemplary embodiment of the present disclosure will be described with reference to the drawings. Identical or equivalent constituents and parts are designated by identical reference symbols in each drawing. In each drawing, one determined direction may be referred to as an X direction, and a direction orthogonal to the one direction may be referred to as a Y direction. Dimensional ratios in the drawings are exaggerated for convenience of description and may be different from actual ratios.

### [First Exemplary Embodiment]

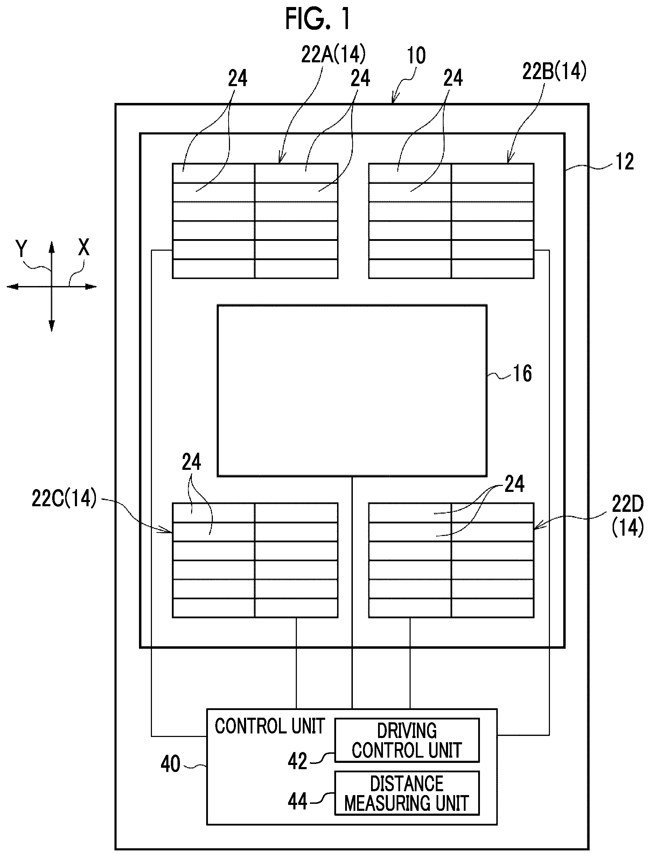

Fig. 1 illustrates a configuration of a distance measuring apparatus 10 according to a first exemplary embodiment.

### <Configuration of Distance Measuring Apparatus>

As illustrated in Fig. 1, the distance measuring apparatus 10 includes an optical device 12 and a control unit 40. The optical device 12 includes a light source unit 14 and a light receiving unit 16.

The light source unit 14 includes a plurality of (for example, four) light sources 22A, 22B, 22C, and 22D, and the plurality of light sources 22A, 22B, 22C, and 22D irradiate different regions, respectively. Each of the light sources 22A, 22B, 22C, and 22D includes a plurality of divided light emitting sections 24.

For example, the light sources 22A, 22B, 22C, and 22D are configured with VCSELs. The VCSELs are semiconductor laser array elements capable of emitting a beam in a direction perpendicular to a substrate surface. In the first exemplary embodiment, the four light sources 22A, 22B, 22C, and 22D will be referred to as the light sources 22A, 22B, 22C, and 22D in a case where distinction among the four light sources 22A, 22B, 22C, and 22D is necessary. The four light sources 22A, 22B, 22C, and 22D may be referred to as the light sources 22 without A, B, C, and D after reference symbol 22 in a case where the distinction among the four light sources 22A, 22B, 22C, and 22D is not necessary.

The light receiving unit 16 receives reflected light of light emitted from the four light sources 22A, 22B, 22C, and 22D to a detection target object (not illustrated). The light receiving unit 16 includes a sensor array including a plurality of pixels. Disposition of the four light sources 22A, 22B, 22C, and 22D of the light source unit 14 and the light receiving unit 16 will be described in detail later.

The control unit 40 includes a driving control unit 42 and a distance measuring unit 44. The control unit 40 is electrically connected to each of the four light sources 22A, 22B, 22C, and 22D of the light source unit 14 and the light receiving unit 16.

The driving control unit 42 controls driving of the four light sources 22A, 22B, 22C, and 22D of the light source unit 14. The driving control unit 42 also controls driving of the light receiving unit 16.

The distance measuring unit 44 performs distance measuring of the detection target object in accordance with a waveform of the light received by the light receiving unit 16. Here, "distance measuring" refers to measuring of a distance to the detection target object. That is, the distance measuring apparatus of the present disclosure is a distance measurement apparatus that measures the distance to the detection target object.

The distance measuring unit 44 is an optical distance measuring device that obtains an image of the distance to the detection target object by calculating a difference in time or a difference in phase between waveforms measured in each pixel of the light receiving unit 16 and waveforms of the four light sources 22A, 22B, 22C, and 22D of the light source unit 14.

### <Hardware Configuration of Distance Measuring Apparatus>

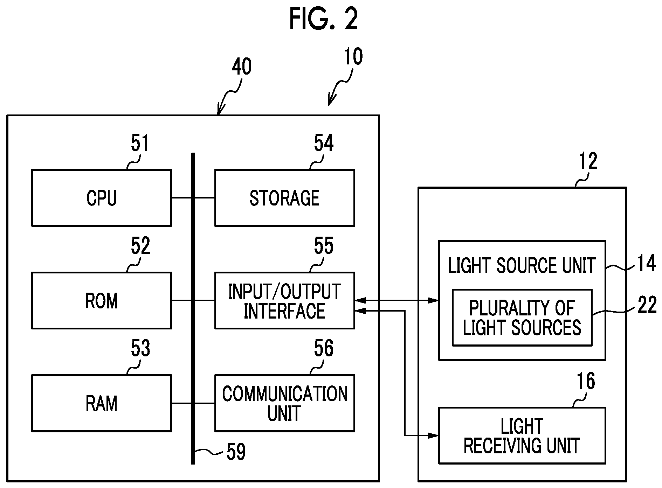

Fig. 2 is a block diagram illustrating a hardware configuration of the distance measuring apparatus 10 according to the first exemplary embodiment.

As illustrated in Fig. 2, the distance measuring apparatus 10 includes the control unit 40 and the optical device 12.

The control unit 40 includes each configuration of a central processing unit (CPU) 51, a read only memory (ROM) 52, a random access memory (RAM) 53, a storage 54, an input/output interface 55, and a communication unit 56. These configurations are connected to be capable of communicating with each other via a bus 59.

The optical device 12 includes the light source unit 14 and the light receiving unit 16. The light source unit 14 includes the plurality of (for example, four) light sources 22. The hardware configuration of the distance measuring apparatus 10 related to the present disclosure is illustrated, and the distance measuring apparatus 10 may include other configurations.

The CPU 51 is a central processing unit and executes various programs or controls each unit. The CPU 51 is an example of a processor. That is, the CPU 51 reads a program from the ROM 52 or the storage 54 and executes the program using the RAM 53 as a work region. The CPU 51 controls each of the configurations and performs various types of operation processing in accordance with the program stored in the ROM 52 or the storage 54. In the first present exemplary embodiment, the ROM 52 or the storage 54 stores a distance measuring processing program. The CPU 51 functions as the distance measuring unit 44 that obtains the image of the distance to the detection target object by calculating the difference in time or the difference in phase between the waveforms measured in each pixel of the light receiving unit 16 and the waveforms of the four light sources 22A, 22B, 22C, and 22D of the light source unit 14.

The ROM 52 stores various programs and various types of data. The RAM 53 temporarily stores a program or data as the work region. The storage 54 is configured with a hard disk drive (HDD) or a solid state drive (SSD) and stores various programs including an operating system and various types of data.

The input/output interface 55 is an interface for transmitting and receiving information and the like to and from each constituent mounted in the distance measuring apparatus 10. The CPU 51 controls operations of the plurality of (for example, four) light sources 22 in the light source unit 14 and the light receiving unit 16 via the input/output interface 55.

The communication unit 56 is an interface for communicating with other apparatuses and, for example, uses a standard such as Ethernet (registered trademark), FDDI, or Wi-Fi (registered trademark). For example, the communication unit 56 can communicate with a user terminal as another apparatus. The communication unit 56 may display a measuring result of the distance to the detection target object from the distance measuring apparatus 10 on the user terminal by transmitting the measuring result to the user terminal.

### <Distance Measuring Apparatus of First Comparative Example and Distance Measuring Apparatus of Second Comparative Example>

Here, a distance measuring apparatus of a first comparative example and a distance measuring apparatus of a second comparative example will be described.

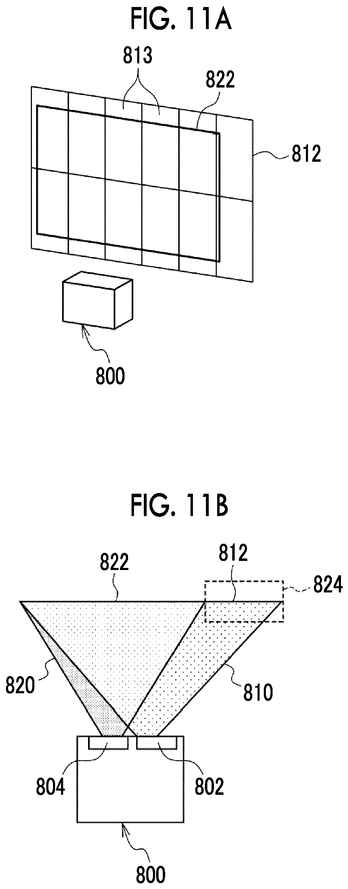

Fig. 11A is a perspective view illustrating a situation on a projection surface of a distance measuring apparatus 800 of the first comparative example, and Fig. 11B is a side view illustrating the situation on the projection surface of the distance measuring apparatus 800 of the first comparative example.

As illustrated in Fig. 11B, the distance measuring apparatus 800 includes a light source 802 and a light receiving unit 804. The light source 802 irradiates the detection target object with light. The light receiving unit 804 receives reflected light of the light emitted from the light source 802 to the detection target object. The light receiving unit 804 is disposed adjacent to one side of the light source 802.

The light source 802 has a transmission (Tx) function, and the light receiving unit 804 has a reception (Rx) function. The light source 802 includes a plurality of divided light emitting sections. Thus, an irradiation region 812 of the light source 802 is configured with irradiation sections 813 corresponding to the light emitting sections (see Fig. 11A). In a case where the light source 802 including the plurality of light emitting sections is used, mechanical disposition of the light source 802 and the light receiving unit 804 may affect a sensible angle of view or boundaries of the angle of view and further affect power consumption.

In the distance measuring apparatus 800, an angle of view (FoI) 810 of the light source 802 is generally set to be larger than an angle of view (FoV) 820 of the light receiving unit 804 (see Fig. 11B). The angle of view indicates an angular range of a space captured in the image. Thus, as illustrated in Figs. 11A and 11B, the irradiation region 812 of the light source 802 is larger than a light receiving region 822 of the light receiving unit 804. In addition, light with which the outside of the angle of view (FoV) 814 of the image of the distance acquired by the light receiving unit 804 is irradiated is unnecessary light that is irrelevant to the distance measuring. Even in a case where spatial disposition of the light source 802 and the light receiving unit 804 is devised, the irradiation region 812 and the light receiving region 822 cannot coincide with each other, and an invalid region 824 (see Fig. 11B) has to be allowed.

In a case where the light source 802 including the plurality of light emitting sections is used, in order to maximize noise removal performance achieved by dividing the irradiation region 812, irradiation needs to be performed by dividing the angle of view (FoV) 820 as evenly as possible, in addition to bringing the angle of view (FoI) 810 and the angle of view (FoV) 820 closer to each other.

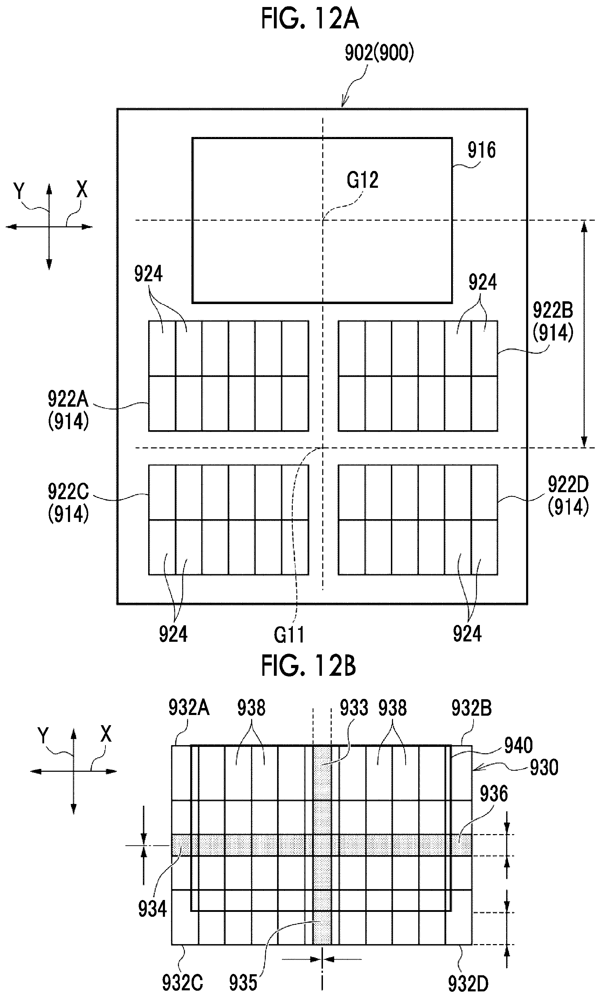

Fig. 12A is a configuration diagram illustrating an optical device 902 of a distance measuring apparatus 900 of the second comparative example, and Fig. 12B is a diagram illustrating a situation on a projection surface of the distance measuring apparatus 900 of the second comparative example. The situation on the projection surface is a state where the detection target object is projected to an expected surface.

As illustrated in Fig. 12A, the optical device 902 of the distance measuring apparatus 900 of the second comparative example includes a light source unit 914 and a light receiving unit 916. In the light source unit 914, four light sources 922A, 922B, 922C, and 922D are disposed, and the four light sources 922A, 922B, 922C, and 922D irradiate different regions, respectively. Each of the four light sources 922A, 922B, 922C, and 922D includes a plurality of divided light emitting sections 924. The four light sources 922A, 922B, 922C, and 922D have equal shapes and equal disposition of the light emitting sections 924. The light emitting sections 924 have rectangular shapes that are long in the Y direction. Total 12 light emitting sections 924 of two columns in the Y direction and six columns in the X direction are disposed.

The four light sources 922A, 922B, 922C, and 922D are disposed on only one side of the light receiving unit 916 in the Y direction. That is, the light sources 922A and 922B and the light sources 922C and 922D are disposed in two columns on one side of the light receiving unit 916 in the Y direction.

In the distance measuring apparatus 900, a centroid G11 of the light source unit 914 and a centroid G12 of the light receiving unit 916 do not overlap with each other. That is, the centroid G11 of the light source unit 914 and the centroid G12 of the light receiving unit 916 are positioned away from each other in the Y direction.

As illustrated in Fig. 12B, an irradiation region 930 of the light source unit 914 is larger than a light receiving region 940 of the light receiving unit 916 on the projection surface of the distance measuring apparatus 900. The irradiation region 930 is the whole irradiation range of irradiation regions 932A, 932B, 932C, and 932D irradiated with light from the four light sources 922A, 922B, 922C, and 922D, respectively. For example, in the irradiation region 930, an overlapping portion 933 in which the irradiation region 932A and the irradiation region 932B overlap with each other in adjacent regions is formed. In addition, in the irradiation region 930, an overlapping portion 934 in which the irradiation region 932A and the irradiation region 932C overlap with each other in adjacent regions is formed. In addition, in the irradiation region 930, an overlapping portion 935 in which the irradiation region 932C and the irradiation region 932D overlap with each other in adjacent regions is formed. Furthermore, in the irradiation region 930, an overlapping portion 936 in which the irradiation region 932B and the irradiation region 932D overlap with each other in adjacent regions is formed. All of the irradiation regions 932A, 932B, 932C, and 932D overlap with each other in a center portion of the irradiation region 930.

Each of the irradiation regions 932A, 932B, 932C, and 932D is configured with irradiation sections 938 corresponding to the plurality of light emitting sections 924.

In a case where the plurality of light sources 922A, 922B, 922C, and 922D are disposed, regions irradiated by the light sources 922A, 922B, 922C, and 922D can be brought closer to each other by disposing the plurality of light sources 922A, 922B, 922C, and 922D closer to each other. Thus, in the distance measuring apparatus 900, the plurality of light sources 922A, 922B, 922C, and 922D are collectively disposed on one direction side of the light receiving unit 916. However, in a case where the light sources 922A, 922B, 922C, and 922D each including the plurality of divided light emitting sections 924 are used, a difference in overlapping between each light emitting section 924 and the light receiving region 940 is noticeable. Accordingly, an unnecessary irradiation time may occur. In addition, the number of divided light emitting sections 924 within an angle of view of the light receiving unit 916 (for example, see the light receiving region 940) may be decreased.

### <Disposition of Plurality of Light Sources of light Source Unit and Light Receiving Unit in Distance Measuring Apparatus of First Exemplary Embodiment>

Next, disposition of the plurality of (for example, four) light sources 22A, 22B, 22C, and 22D of the light source unit 14 and the light receiving unit 16 in the distance measuring apparatus 10 of the first exemplary embodiment will be described.

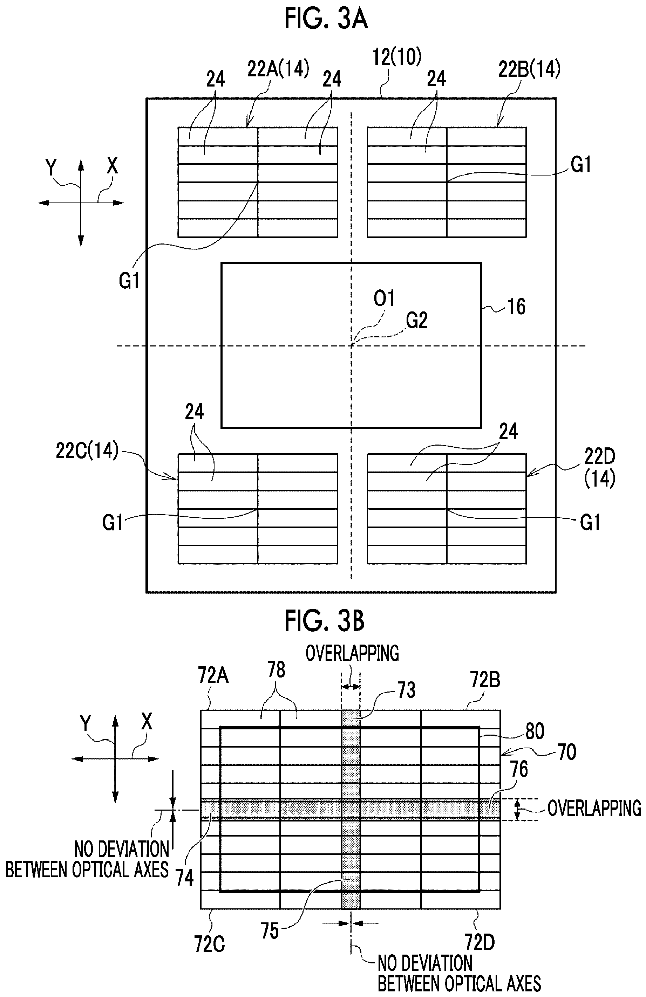

Fig. 3A is a configuration diagram illustrating the optical device 12 of the distance measuring apparatus 10 of the first exemplary embodiment, and Fig. 3B is a diagram illustrating a situation on a projection surface of the distance measuring apparatus 10 of the first exemplary embodiment.

As illustrated in Figs. 1 and 3A, in distance measuring apparatus 10, the light source unit 14 includes four light sources 22A, 22B, 22C, and 22D. One light receiving unit 16 is disposed. Here, the light sources 22A, 22B, 22C, and 22D refer to regions surrounding the outermost portion of only parts in which light is emitted. The light receiving unit 16 refers to a region surrounding the outermost portion of only a part in which light is received. The four light sources 22A, 22B, 22C, and 22D of the light source unit 14 are disposed with the light receiving unit 16 interposed among the four light sources 22A, 22B, 22C, and 22D. For example, the light sources 22A, 22B, 22C, and 22D are disposed with the light receiving unit 16 interposed among the light sources 22A, 22B, 22C, and 22D in the Y direction and are disposed with the light receiving unit 16 not interposed among the light sources 22A, 22B, 22C, and 22D in the X direction orthogonal to the Y direction. In the first exemplary embodiment, the Y direction is an example of a first direction, and the X direction is an example of a second direction.

For example, the four light sources 22A, 22B, 22C, and 22D are evenly disposed on both sides of the light receiving unit 16. For example, the light sources 22A and 22B are disposed on one side in the Y direction in which the light receiving unit 16 is interposed, and the light sources 22C and 22D are disposed on the other side in the Y direction in which the light receiving unit 16 is interposed.

Each of the light sources 22A, 22B, 22C, and 22D has the same size and is configured such that the plurality of light emitting sections 24 have the same shape and disposition. For example, the light sources 22A, 22B, 22C, and 22D have rectangular shapes. Definitions of rectangles of the light sources 22A, 22B, 22C, and 22D will be described later.

For example, the light emitting sections 24 have rectangular shapes and have long shapes of which a length in the X direction is longer than a length in the Y direction. Each of the light sources 22A, 22B, 22C, and 22D includes 12 light emitting sections 24. The light emitting sections 24 are disposed in two columns in the X direction and six columns in the Y direction. In the distance measuring apparatus 10, the light sources 22A, 22B, 22C, and 22D are disposed such that long sides of the light emitting sections 24 face each other with the light receiving unit 16 interposed among the light emitting sections 24.

For example, the light receiving unit 16 has a rectangular shape. The four light sources 22A, 22B, 22C, and 22D are disposed on both sides of the light receiving unit 16 at a distance corresponding to a short side of the light receiving unit 16. Two light sources 22A and 22B are disposed along a long side of the light receiving unit 16, and two light sources 22C and 22D are disposed along the long side of the light receiving unit 16.

In the distance measuring apparatus 10, a centroid O1 of the light source unit 14 coincides with a centroid G2 of the light receiving unit 16. The centroid O1 of the light source unit 14 and the centroid G2 of the light receiving unit 16 are substantially close to the center of the drawing. In the gist of the present disclosure, the centroid O1 of the light source unit 14 coincides with the centroid G2 of the light receiving unit 16 not only in a case where the centroid O1 of the light source unit 14 completely coincides with the centroid G2 of the light receiving unit 16 but also in a case where the centroid O1 of the light source unit 14 slightly deviates from the centroid G2 of the light receiving unit 16. In the case of slight deviation, for example, the centroid O1 of the light source unit 14 is, for example, within 10% of a dimension of the light receiving unit 16 in the Y direction and within 10% of a dimension of the light receiving unit 16 in the X direction with respect to the center G2 of the light receiving unit 16. In addition, for example, with respect to the centroid G2 of the light receiving unit 16, the centroid O1 of the light source unit 14 is, for example, within 5% of the dimension of the light receiving unit 16 in the Y direction and within 5% of the dimension of the light receiving unit 16 in the X direction, and, for example, within 3% of the dimension of the light receiving unit 16 in the Y direction and within 3% of the dimension of the light receiving unit 16 in the X direction.

Disposition of the four light sources 22A, 22B, 22C, and 22D of the light source unit 14 is, for example, disposition in which a sum total of distances between the four light sources 22A, 22B, 22C, and 22D and the light receiving unit 16 is smaller than a sum total of distances among the four light sources 22A, 22B, 22C, and 22D. In the first exemplary embodiment, the sum total of the distances among the four light sources 22A, 22B, 22C, and 22D does not include distances between diagonally disposed light sources among the four light sources 22A, 22B, 22C, and 22D. The sum total of the distances among the four light sources 22A, 22B, 22C, and 22D is, for example, a sum total of distances among the centroids G1 of the each of the light sources 22A, 22B, 22C, and 22D. The sum total of the distances between the four light sources 22A, 22B, 22C, and 22D and the light receiving unit 16 is, for example, a sum total of distances between the centroids G1 of each of the light sources 22A, 22B, 22C, and 22D and the centroid G2 of the light receiving unit 16. The centroids G1 of each of the light sources 22A, 22B, 22C, and 22D and the centroid O1 of the light source unit 14 including the four light sources 22A, 22B, 22C, and 22D will be described later.

In the distance measuring apparatus 10, the centroid G1 of the light source unit 14 and the centroid G2 of the light receiving unit 16 are caused to coincide with each other by disposing the four light sources 22A, 22B, 22C, and 22D of the light source unit 14 with the light receiving unit 16 interposed among the four light sources 22A, 22B, 22C, and 22D. Accordingly, since the angle of view (FoI) of the light source unit 14 and the angle of view (FoV) of the light receiving unit 16 can be brought closer to each other, the light emitting sections 24 can be efficiently disposed within the angle of view (FoV) of the light receiving unit 16.

In a direction (for example, the Y direction) in which the four light sources 22A, 22B, 22C, and 22D are disposed on both sides of the light receiving unit 16, an irradiation gap is likely to occur at a center in a short distance (for example, a center in the Y direction). Thus, in the distance measuring apparatus 10, overlapping among irradiation angles of view of the light sources 22A, 22B, 22C, and 22D is set in the direction (for example, the Y direction) in which the irradiation gap at the center is likely to occur. Hereinafter, irradiation regions of the light sources 22A, 22B, 22C, and 22D will be described using Fig. 3B.

As illustrated in Fig. 3B, an irradiation region 70 of the light source unit 14 is larger than a light receiving region 80 of the light receiving unit 16 on the projection surface of the distance measuring apparatus 10. The irradiation region 70 is the whole irradiation range of irradiation regions 72A, 72B, 72C, and 72D irradiated with light from the four light sources 22A, 22B, 22C, and 22D, respectively. The irradiation regions 72A, 72B, 72C, and 72D are examples of the different regions. In the distance measuring apparatus 10, the irradiation regions 72A and 72B of the light sources 22A and 22B on one side in the Y direction and the irradiation regions 72C and 72D of the light sources 22C and 22D on the other side in the Y direction with respect to the light receiving unit 16 are disposed to overlap with each other on a center portion side of the light receiving unit 16.

More specifically, in the irradiation region 70, an overlapping portion 73 in which the irradiation region 72A and the irradiation region 72B overlap with each other in adjacent regions is formed. In addition, in the irradiation region 70, an overlapping portion 74 in which the irradiation region 72A and the irradiation region 72C overlap with each other in adjacent regions is formed. In addition, in the irradiation region 70, an overlapping portion 75 in which the irradiation region 72C and the irradiation region 72D overlap with each other in adjacent regions is formed. Furthermore, in the irradiation region 70, an overlapping portion 76 in which the irradiation region 72B and the irradiation region 72D overlap with each other in adjacent regions is formed. All of the irradiation regions 72A, 72B, 72C, and 72D overlap with each other in a center portion of the irradiation region 70.

Each of the irradiation regions 72A, 72B, 72C, and 72D is configured with irradiation sections 78 corresponding to the plurality of light emitting sections 24.

In the distance measuring apparatus 10, one light emitting section 24 is turned off in a part in which the light emitting sections 24 overlap with each other in the irradiation regions 72A, 72B, 72C, and 72D. For example, in the overlapping portion 74 and the overlapping portion 76, the irradiation sections 78 of the light emitting sections 24 overlap with each other. Thus, one light emitting section 24 is turned off.

### <Definition of Rectangle of Light Source and Position of Centroid of Light Source Unit>

Next, the definition of the rectangle of the light source and a position of the centroid of the light source unit will be described.

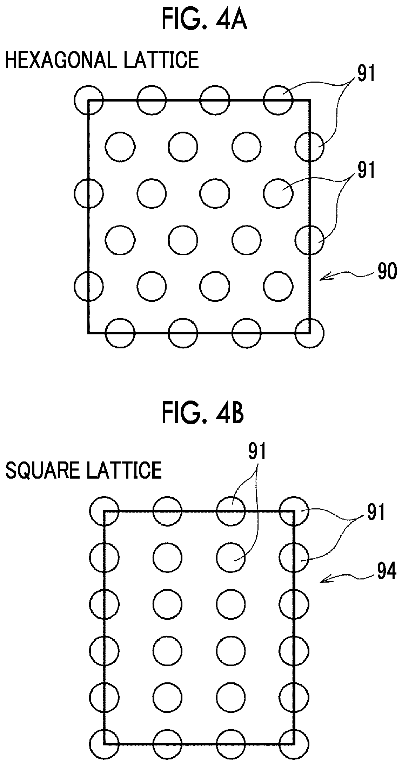

Fig. 4A is a plan view illustrating a light source 90 of a first example. As illustrated in Fig. 4A, in the light source 90 of the first example, a plurality of light emitting points 91 are arranged in a hexagonal lattice. For example, the light emitting points 91 are configured with VCSELs. A rectangle of the light source 90 is a rectangle surrounded by straight lines drawn parallel to a row direction and a column direction from centers of the light emitting points 91 positioned at the outermost position.

Fig. 4B is a plan view illustrating a light source 94 of a second example. As illustrated in Fig. 4B, in the light source 94 of the second example, a plurality of light emitting points 91 are arranged in a square lattice. A rectangle of the light source 94 is a rectangle surrounded by straight lines drawn parallel to the row direction and the column direction from centers of the light emitting points 91 positioned at the outermost position.

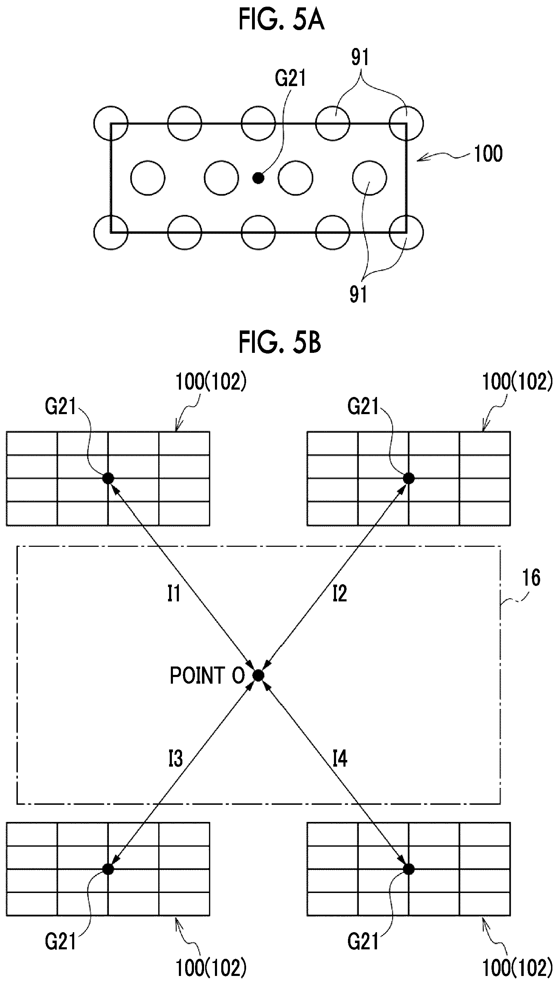

Fig. 5A is a diagram illustrating a position of a centroid of a light source 100. As illustrated in Fig. 5A, a die unit corresponds to one light source 100, and a rectangle surrounded by straight lines drawn parallel to the row direction and the column direction from the centers of the light emitting points 91 positioned at the outermost position is a rectangle of the light source 100 in a two-dimensional view. A center of the rectangle of the light source 90 is a position of a centroid G21. An area of the rectangle of the light source 90 is denoted by Si.

Fig. 5B is a diagram illustrating a position of a centroid of a light source unit 102. As illustrated in Fig. 5B, the light source unit 102 includes a plurality of (for example, four) light sources 100. The four light sources 100 are disposed on both sides of the rectangular light receiving unit 16 in one direction. That is, two light sources 100 are disposed on one side of the light receiving unit 16 in the one direction, and two light sources 100 are disposed on the other side of the light receiving unit 16 in the one direction.

In a case where an area of the rectangle of each light source 100 is denoted by Si, and a distance from the centroid G21 of each light source 100 to any point O is denoted by li, a second moment of area is defined as φ = min.(Σ(Si × li²)) (min. means minimum).

Any point Oa satisfying φ is defined as a centroid of the second moment of area. That is, the centroid O of the light source unit 102 illustrated in Fig. 5B is the centroid of the second moment of area.

The centroid O1 of the light source unit 14 illustrated in Fig. 3A is also the centroid of the second moment of area.

### <Actions and Effects>

Next, actions and effects of the first exemplary embodiment will be described.

The distance measuring apparatus 10 includes the light source unit 14 and the light receiving unit 16. In the light source unit 14, the plurality of (for example, four) light sources 22A, 22B, 22C, and 22D are disposed, and the four light sources 22A, 22B, 22C, and 22D irradiate different regions, respectively. The light receiving unit 16 receives the reflected light of the light emitted from the four light sources 22A, 22B, 22C, and 22D to the detection target object. The four light sources 22A, 22B, 22C, and 22D of the light source unit 14 are disposed with the light receiving unit 16 interposed among the four light sources 22A, 22B, 22C, and 22D. The CPU 51 of the control unit 40 performs the distance measuring of the detection target object (that is, measures the distance to the detection target object) in accordance with the waveform of the light received by the light receiving unit 16.

Generally, in a case where a plurality of light sources are disposed, regions irradiated by the light sources can be brought closer to each other by disposing the plurality of light sources closer to each other. Thus, the plurality of light sources are collectively disposed closer to each other. For example, as illustrated in Fig. 12A, in the distance measuring apparatus 900 of the second comparative example, the regions irradiated by the light sources 922A, 922B, 922C, and 922D can be brought closer to each other by disposing the four light sources 922A, 922B, 922C, and 922D closer to each other. Thus, the four light sources 922A, 922B, 922C, and 922D are collectively disposed on one side of the light receiving unit 916.

However, in a case where the plurality of light sources are collectively disposed closer to each other, a difference in overlapping between each light emitting section and the light receiving region is noticeable in a case where a light source including a plurality of divided light emitting sections is used. For example, as illustrated in Figs. 12A and 12B, in a case where the light sources 922A, 922B, 922C, and 922D each including the plurality of divided light emitting sections 924 are used, a difference in overlapping between each light emitting section 924 and the light receiving region 940 is noticeable. Accordingly, an unnecessary irradiation time may occur. In addition, since the difference in overlapping between each light emitting section 924 and the light receiving region 940 is noticeable, the number of divided light emitting sections 924 within the angle of view of the light receiving unit 916 (for example, the light receiving region 940) may be reduced.

Meanwhile, in the distance measuring apparatus 10 of the first exemplary embodiment, as illustrated in Figs. 3A and 3B, in a case where the light sources 22A, 22B, 22C, and 22D each including the plurality of divided light emitting sections 24 are used, a difference in overlapping between each light emitting section 24 and the light receiving region 80 almost does not occur.

Thus, in the distance measuring apparatus 10, a decrease in the number of divided light emitting sections 24 within the angle of view of the light receiving unit 16 may be reduced compared to a case where a plurality of light sources each including a plurality of divided light emitting sections are collectively disposed on one side of a light receiving unit.

In the distance measuring apparatus 10, the centroid O1 of the light source unit 14 coincides with the centroid G2 of the light receiving unit 16. Thus, in the distance measuring apparatus 10, a decrease in the number of divided light emitting sections 24 within the angle of view of the light receiving unit 16 may be reduced compared to a case where the centroid of the light source unit is separated from the centroid of the light receiving unit. For example, as illustrated in Figs. 12A and 12B, a decrease in the number of divided light emitting sections 24 within the angle of view of the light receiving unit 16 may be reduced compared to a case where the centroid G11 of the light source unit 914 is separated from the centroid G12 of the light receiving unit 916.

Disposition of the plurality of (for example, four) light sources 22 of the light source unit 14 is disposition in which the sum total of the distances between the light sources 22A, 22B, 22C, and 22D and the light receiving unit 16 is smaller than the sum total of the distances among the four light sources 22A, 22B, 22C, and 22D. In the first exemplary embodiment, the sum total of the distances among the four light sources 22A, 22B, 22C, and 22D does not include distances between diagonally disposed light sources among the four light sources 22A, 22B, 22C, and 22D. For example, the sum total of the distances between the centroids G1 of the light sources 22A, 22B, 22C, and 22D and the centroid G2 of the light receiving unit 16 is smaller than the sum total of the distances among the centroids G1 of the plurality of light sources 22A, 22B, 22C, and 22D. Thus, in the distance measuring apparatus 10, a decrease in the number of divided light emitting sections 24 within the angle of view of the light receiving unit 16 may be reduced compared to a case where disposition of a plurality of light sources is disposition in which a sum total of distances between the light sources and a light receiving unit is larger than a sum total of distances among the plurality of light sources.

In the distance measuring apparatus 10, the light source unit 14 includes four or more light sources 22. The light sources 22 are disposed with the light receiving unit 16 interposed among the light sources 22 in the Y direction and are disposed with the light receiving unit 16 not interposed among the light sources 22 in the X direction orthogonal to the Y direction. Thus, in the distance measuring apparatus 10, a decrease in the number of divided light emitting sections 24 within the angle of view of the light receiving unit 16 may be reduced in the configuration in which the light sources 22 are disposed with the light receiving unit 16 interposed among the light sources 22 in the Y direction and are disposed with the light receiving unit 16 not interposed among the light sources 22 in the X direction orthogonal to the Y direction.

In the distance measuring apparatus 10, the light emitting sections 24 have rectangular shapes, and the light sources 22 are disposed such that the long sides of the light emitting sections 24 face each other with the light receiving unit 16 interposed among the light emitting sections 24. Furthermore, the irradiation regions 72A and 72B of the light sources 22A and 22B on one side and the irradiation regions 72C and 72D of the light sources 22C and 22D on the other side with respect to the light receiving unit 16 are disposed to overlap with each other on the center portion side of the light receiving unit 16. Thus, in the distance measuring apparatus 10, occurrence of the irradiation gap among the plurality of light sources 22A, 22B, 22C, and 22D in the center portion of the light receiving unit 16 is reduced compared to a case where light emitting sections closer to a light receiving unit do not overlap with each other in an irradiation region.

In the distance measuring apparatus 10, one light emitting section 24 is turned off in the part in which the light emitting sections 24 overlap with each other in the irradiation regions 72A, 72B, 72C, and 72D. Thus, in the distance measuring apparatus 10, power consumption can be reduced compared to a case where both of light emitting sections emit light in a part in which the light emitting sections overlap with each other in an irradiation region.

In the distance measuring apparatus 10, the plurality of light sources 22A, 22B, 22C, and 22D are evenly disposed on both sides of the light receiving unit 16. Thus, in the distance measuring apparatus 10, a decrease in the number of divided light emitting sections 24 within the angle of view of the light receiving unit 16 may be reduced compared to a case where a plurality of light sources are disposed at different positions on both sides of a light receiving unit.

In the distance measuring apparatus 10, the light receiving unit 16 has a rectangular shape. Furthermore, the plurality of light sources 22A, 22B, 22C, and 22D are disposed on both sides of the light receiving unit 16 at the distance corresponding to the short side of the light receiving unit 16. Thus, in the distance measuring apparatus 10, the occurrence of the irradiation gap among the plurality of light sources 22A, 22B, 22C, and 22D in the center portion of the light receiving unit 16 is reduced compared to a case where a plurality of light sources are disposed on both sides of a light receiving unit at a distance corresponding to a long side of the light receiving unit.

In the distance measuring apparatus 10, the plurality of light sources 22 are disposed along the long side of the light receiving unit 16. For example, two light sources 22A and 22B are disposed along the long side of the light receiving unit 16, and two light sources 22C and 22D are disposed along the long side of the light receiving unit 16. Thus, in the distance measuring apparatus 10, a decrease in the number of divided light emitting sections 24 within the angle of view of the light receiving unit 16 may be reduced compared to a case where one light source is disposed along a long side of a light receiving unit.

### [Second Exemplary Embodiment]

Next, a distance measuring apparatus according to a second exemplary embodiment will be described. Constituents identical to the first exemplary embodiment described above will be denoted by identical reference symbols and will not be described.

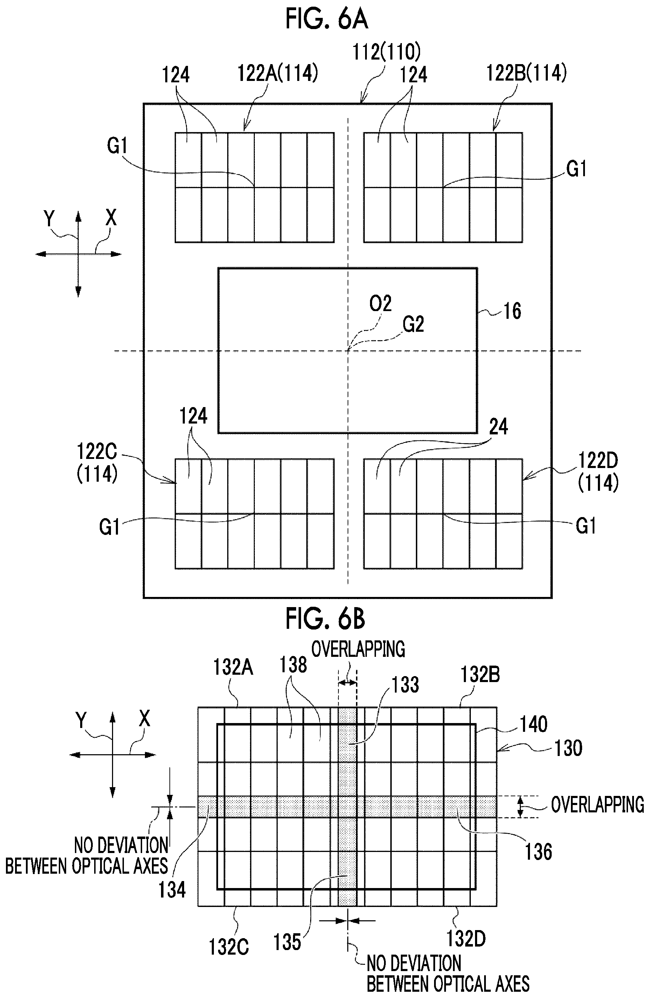

Fig. 6A is a configuration diagram illustrating an optical device 112 of a distance measuring apparatus 110 of the second exemplary embodiment, and Fig. 6B is a diagram illustrating a situation on a projection surface of the distance measuring apparatus 110 of the second exemplary embodiment.

As illustrated in Fig. 6A, in the distance measuring apparatus 110, a light source unit 114 includes four light sources 122A, 122B, 122C, and 122D, and this point is the same as the light source unit 14 of the distance measuring apparatus 10 according to the first exemplary embodiment. However, shapes and disposition of light emitting sections 124 are different. In the distance measuring apparatus 110, the light sources 122A, 122B, 122C, and 122D have rectangular shapes and have the same size. The light sources 122A and 122B are disposed on one side in the Y direction in which the light receiving unit 16 is interposed, and the light sources 122C and 122D are disposed on the other side in the Y direction in which the light receiving unit 16 is interposed. This point is the same as the light source unit 14 of the distance measuring apparatus 10 of the first exemplary embodiment.

The light emitting sections 124 have rectangular shapes of which a length in the Y direction is longer than a length in the X direction. This point is different from the light source unit 14 of the distance measuring apparatus 10 of the first exemplary embodiment. Each of the light sources 122A, 122B, 122C, and 122D includes 12 light emitting sections 124. The light emitting sections 124 are disposed in six columns in the X direction and two columns in the Y direction.

In the distance measuring apparatus 110, the light emitting sections 124 are disposed such that short sides of the light emitting sections 124 face each other with the light receiving unit 16 interposed among the light emitting sections 124.

In the distance measuring apparatus 110, a centroid O2 of the light source unit 114 including the four light sources 122A, 122B, 122C, and 122D coincides with the centroid G2 of the light receiving unit 16.

As illustrated in Fig. 6B, an irradiation region 130 of the light source unit 114 is larger than a light receiving region 140 of the light receiving unit 16 on the projection surface of the distance measuring apparatus 110. In the distance measuring apparatus 110, irradiation regions 132A and 132B of the light sources 122A and 122B on one side in the Y direction and irradiation regions 132C and 132D of the light sources 122C and 122D on the other side in the Y direction with respect to the light receiving unit 16 are disposed to overlap with each other on the center portion side of the light receiving unit 16. The irradiation regions 132A, 132B, 132C, and 132D are examples of the different regions.

More specifically, in the irradiation region 130, an overlapping portion 133 in which the irradiation region 132A and the irradiation region 132B overlap with each other in adjacent regions is formed. In addition, in the irradiation region 130, an overlapping portion 134 in which the irradiation region 132A and the irradiation region 132C overlap with each other in adjacent regions is formed. In addition, in the irradiation region 130, an overlapping portion 135 in which the irradiation region 132C and the irradiation region 132D overlap with each other in adjacent regions is formed. Furthermore, in the irradiation region 130, an overlapping portion 136 in which the irradiation region 132B and the irradiation region 132D overlap with each other in adjacent regions is formed.

Each of the irradiation regions 132A, 132B, 132C, and 132D is configured with irradiation sections 138 corresponding to the plurality of light emitting sections 124. At least a part of all of the light emitting sections 124 falls within the light receiving region 140 of the light receiving unit 16. Other configurations of the distance measuring apparatus 110 of the second exemplary embodiment are the same as the configurations of the distance measuring apparatus 10 of the first exemplary embodiment.

In the distance measuring apparatus 110 of the second exemplary embodiment, the following actions and effects are obtained in addition to the actions and effects of the same configuration as the distance measuring apparatus 10 of the first exemplary embodiment.

In the distance measuring apparatus 110, the light emitting sections 124 have rectangular shapes and are disposed such that the short sides of the light emitting sections 124 face each other with the light receiving unit 16 interposed among the light emitting sections 124. Furthermore, at least a part of all of the light emitting sections 124 falls within the light receiving region 140 of the light receiving unit 16. Thus, in the distance measuring apparatus 110, a decrease in the number of divided light emitting sections 124 within the angle of view of the light receiving unit 16 may be reduced compared to a case where a part of light emitting sections does not fall within a light receiving region of a light receiving unit.

### [Third Exemplary Embodiment]

Next, a distance measuring apparatus according to a third exemplary embodiment will be described. Constituents identical to the first and second exemplary embodiments described above will be denoted by identical reference symbols and will not be described.

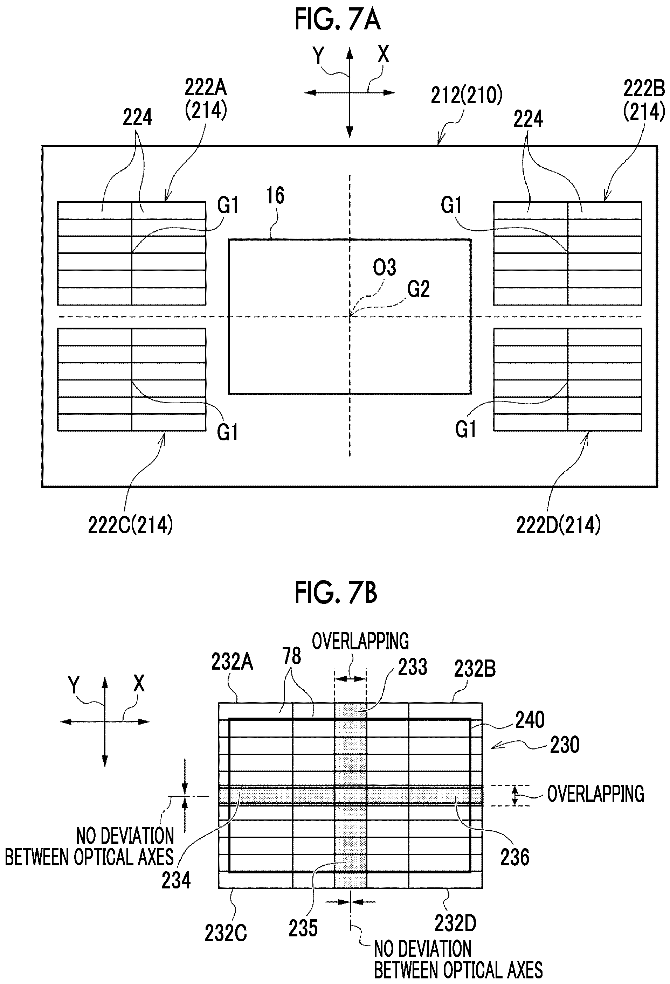

Fig. 7A is a configuration diagram illustrating an optical device 212 of a distance measuring apparatus 210 of the third exemplary embodiment, and Fig. 7B is a diagram illustrating a situation on a projection surface of the distance measuring apparatus 210 of the third exemplary embodiment.

As illustrated in Fig. 7A, in the distance measuring apparatus 210, a light source unit 214 includes four light sources 222A, 222B, 222C, and 222D, and this point is the same as the light source unit 14 of the distance measuring apparatus 10 according to the first exemplary embodiment. However, directions in which the four light sources 222A, 222B, 222C, and 222D are disposed with respect to the light receiving unit 16 are different. The light sources 222A, 222B, 222C, and 222D are disposed with the light receiving unit 16 interposed among the light sources 222A, 222B, 222C, and 222D in the X direction and are disposed with the light receiving unit 16 not interposed among the light sources 222A, 222B, 222C, and 222D in the Y direction orthogonal to the X direction. In the third exemplary embodiment, the X direction is an example of the first direction, and the Y direction is an example of the second direction.

For example, the four light sources 222A, 222B, 222C, and 222D are evenly disposed on both sides of the light receiving unit 16. For example, the light sources 222A and 222B are disposed on one side in the X direction in which the light receiving unit 16 is interposed, and the light sources 222C and 222D are disposed on the other side in the X direction in which the light receiving unit 16 is interposed.

The light sources 222A, 222B, 222C, and 222D have rectangular shapes. Each of the light sources 222A, 222B, 222C, and 222D includes a plurality of light emitting sections 24, as in the first exemplary embodiment.

In the distance measuring apparatus 210, the light sources 222A, 222B, 222C, and 222D are disposed such that short sides of the light emitting sections 24 face each other with the light receiving unit 16 interposed among the light emitting sections 24.

The light receiving unit 16 has a rectangular shape, and the four light sources 222A, 222B, 222C, and 222D are disposed on both sides of the light receiving unit 16 at a distance corresponding to the long side of the light receiving unit 16. Two light sources 222A and 222C are disposed along the short side of the light receiving unit 16, and two light sources 222B and 222D are disposed along the short side of the light receiving unit 16.

In the distance measuring apparatus 210, a centroid O3 of the light source unit 214 including the four light sources 222A, 222B, 222C, and 222D coincides with the centroid G2 of the light receiving unit 16.

As illustrated in Fig. 7B, an irradiation region 230 of the light source unit 214 is larger than a light receiving region 240 of the light receiving unit 16 on the projection surface of the distance measuring apparatus 210. In the distance measuring apparatus 210, irradiation regions 232A and 232C of the light sources 222A and 222C on one side in the X direction and irradiation regions 232B and 232D of the light sources 222B and 222D on the other side in the X direction with respect to the light receiving unit 16 are disposed to overlap with each other on the center portion side of the light receiving unit 16. The irradiation regions 232A, 232B, 232C, and 232D are examples of the different regions.

More specifically, in the irradiation region 230, an overlapping portion 233 in which the irradiation region 232A and the irradiation region 232B overlap with each other in adjacent regions is formed. In addition, in the irradiation region 230, an overlapping portion 234 in which the irradiation region 232A and the irradiation region 232C overlap with each other in adjacent regions is formed. In addition, in the irradiation region 230, an overlapping portion 235 in which the irradiation region 232C and the irradiation region 232D overlap with each other in adjacent regions is formed. Furthermore, in the irradiation region 230, an overlapping portion 236 in which the irradiation region 232B and the irradiation region 232D overlap with each other in adjacent regions is formed.

Each of the irradiation regions 232A, 232B, 232C, and 232D is configured with irradiation sections 78 corresponding to the plurality of light emitting sections 24. Other configurations of the distance measuring apparatus 210 of the third exemplary embodiment are the same as the configurations of the distance measuring apparatus 10 of the first exemplary embodiment.

In the distance measuring apparatus 210 of the third exemplary embodiment, the following actions and effects are obtained in addition to the actions and effects of the same configuration as the distance measuring apparatus 10 of the first exemplary embodiment.

In the distance measuring apparatus 210, the light receiving unit 16 has a rectangular shape, and the plurality of (for example, four) light sources 222A, 222B, 222C, and 222D are disposed on both sides of the light receiving unit 16 at the distance corresponding to the long side of the light receiving unit 16. Two light sources 222A and 222C are disposed along the short side of the light receiving unit 16, and two light sources 222B and 222D are disposed along the short side of the light receiving unit 16. Thus, in the distance measuring apparatus 210, a decrease in the number of divided light emitting sections 24 within the angle of view of the light receiving unit 16 may be reduced compared to a case where one light source is disposed along a short side of a light receiving unit.

### [Fourth Exemplary Embodiment]

Next, a distance measuring apparatus according to a fourth exemplary embodiment will be described. Constituents identical to the first to third exemplary embodiments described above will be denoted by identical reference symbols and will not be described.

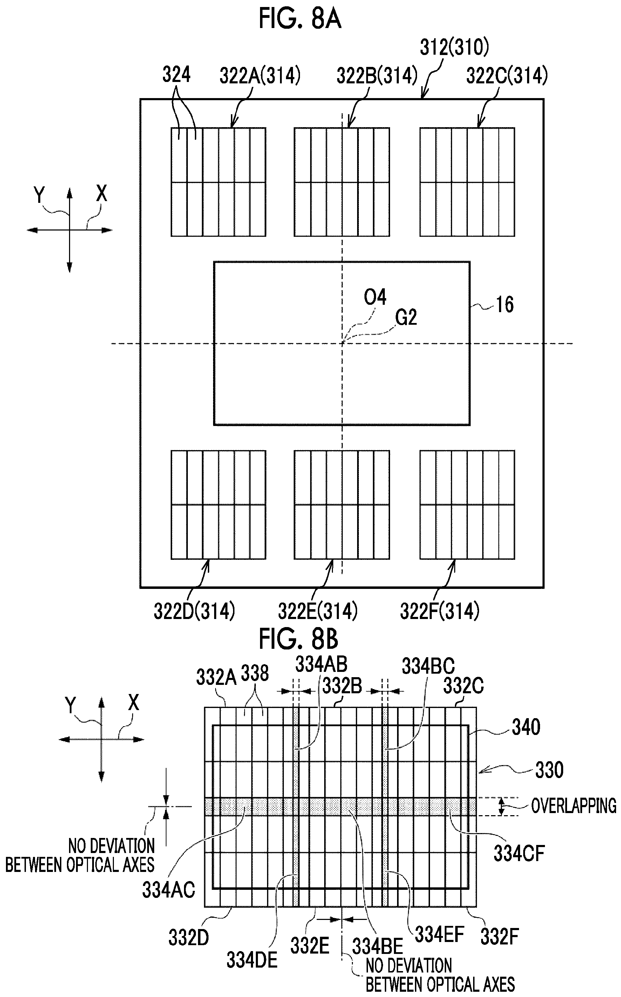

Fig. 8A is a configuration diagram illustrating an optical device 312 of a distance measuring apparatus 310 of the fourth exemplary embodiment, and Fig. 8B is a diagram illustrating a situation on a projection surface of the distance measuring apparatus 310 of the fourth exemplary embodiment.

As illustrated in Fig. 8A, in the distance measuring apparatus 310, a light source unit 314 includes six light sources 322A, 322B, 322C, 322D, 322E, and 322F, and this point is different from the light source unit 14 of the distance measuring apparatus 10 of the first exemplary embodiment. Furthermore, a plurality of light emitting sections 324 have different disposition and shapes from the light emitting sections 24 of the distance measuring apparatus 10 of the first exemplary embodiment.

In the distance measuring apparatus 310, the six light sources 322A, 322B, 322C, 322D, 322E, and 322F are evenly disposed on both sides of the light receiving unit 16. The light sources 322A, 322B, and 322C are disposed on one side in the Y direction in which the light receiving unit 16 is interposed, and the light sources 322D, 322E, and 322F are disposed on the other side in the Y direction in which the light receiving unit 16 is interposed. For example, the six light sources 322A, 322B, 322C, 322D, 322E, and 322F are disposed on both sides of the light receiving unit 16 at the distance corresponding to the short side of the light receiving unit 16.

The light emitting sections 324 have rectangular shapes of which a length in the Y direction is longer than a length in the X direction. Each of the light sources 322A, 322B, 322C, 322D, 322E, and 322F includes 12 light emitting sections 324. The light emitting sections 324 are disposed in six columns in the X direction and two columns in the Y direction.

In the distance measuring apparatus 310, the light emitting sections 324 are disposed such that short sides of the light emitting sections 324 face each other with the light receiving unit 16 interposed among the light emitting sections 324.

In the distance measuring apparatus 310, a centroid O4 of the light source unit 314 including the six light sources 322A, 322B, 322C, 322D, 322E, and 322F coincides with the centroid G2 of the light receiving unit 16.

As illustrated in Fig. 8B, an irradiation region 330 of the light source unit 314 is larger than a light receiving region 340 of the light receiving unit 16 on the projection surface of the distance measuring apparatus 310. In the distance measuring apparatus 310, irradiation regions 332A, 332B, and 332C of the light sources 322A, 322B, and 322C on one side in the Y direction and irradiation regions 332D, 332E, and 332F of the light sources 322D, 322E, and 322F on the other side in the Y direction with respect to the light receiving unit 16 are disposed to overlap with each other on the center portion side of the light receiving unit 16. The irradiation regions 332A, 332B, 332C, 332D, 332E, and 332F are examples of the different regions.

In the irradiation region 330, overlapping portions 334AB, 334AC, 334BC, 334BE, 334CF, 334DE, and 334EF are formed by causing the irradiation regions 332A, 332B, 332C, 332D, 332E, and 332F to overlap with each other.

Each of the irradiation regions 332A, 332B, 332C, 332D, 332E, and 332F is configured with irradiation sections 338 corresponding to the plurality of light emitting sections 324. At least a part of all of the light emitting sections 324 falls within the light receiving region 340 of the light receiving unit 16. Other configurations of the distance measuring apparatus 310 of the fourth exemplary embodiment are the same as the configurations of the distance measuring apparatus 10 of the first exemplary embodiment and the distance measuring apparatus 110 of the second exemplary embodiment.

In the distance measuring apparatus 310 of the fourth exemplary embodiment, the same actions and effects are obtained by the same configurations as the distance measuring apparatus 10 of the first exemplary embodiment and the distance measuring apparatus 110 of the second exemplary embodiment.

### [Fifth Exemplary Embodiment]

Next, a distance measuring apparatus according to a fifth exemplary embodiment will be described. Constituents identical to the first to fourth exemplary embodiments described above will be denoted by identical reference symbols and will not be described.

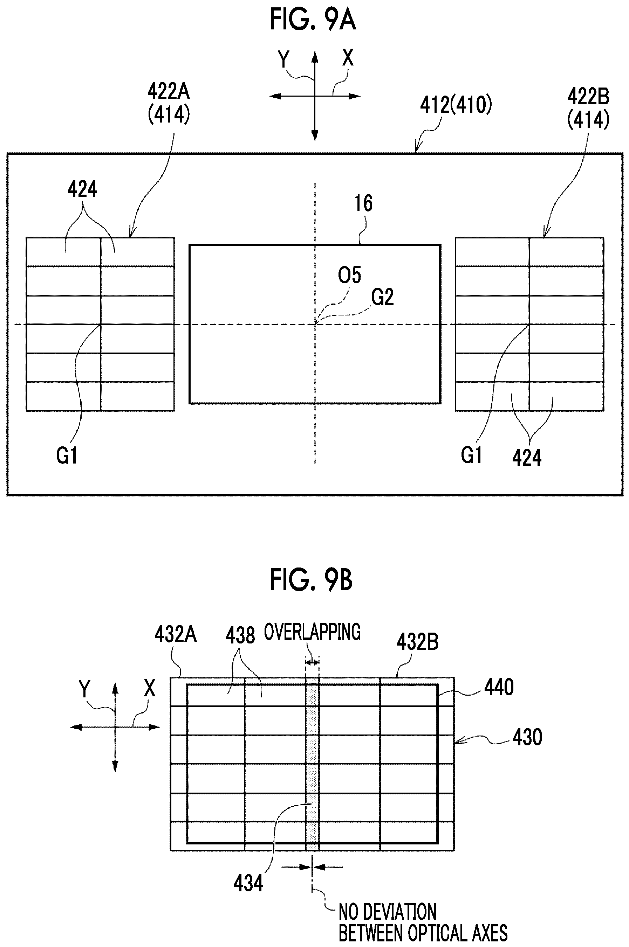

Fig. 9A is a configuration diagram illustrating an optical device 412 of a distance measuring apparatus 410 of the fifth exemplary embodiment, and Fig. 9B is a diagram illustrating a situation on a projection surface of the distance measuring apparatus 410 of the fifth exemplary embodiment.

As illustrated in Fig. 9A, in the distance measuring apparatus 410, a light source unit 414 includes two light sources 422A and 422B, and this point is different from the light source unit 14 of the distance measuring apparatus 10 of the first exemplary embodiment and the light source unit 214 of the distance measuring apparatus 210 of the third exemplary embodiment.

In the distance measuring apparatus 410, the two light sources 422A and 422B are evenly disposed on both sides of the light receiving unit 16 in the X direction. For example, the two light sources 422A and 422B are disposed on both sides of the light receiving unit 16 at the distance corresponding to the long side of the light receiving unit 16.

Light emitting sections 424 have rectangular shapes of which a length in the X direction is longer than a length in the Y direction. Each of the light sources 422A and 422B includes 12 light emitting sections 424. The light emitting sections 424 are disposed in two columns in the X direction and six columns in the Y direction. The light emitting sections 424 are disposed such that short sides of the light emitting sections 424 face each other with the light receiving unit 16 interposed among the light emitting sections 424.

In the distance measuring apparatus 410, a centroid O5 of the light source unit 414 including the two light sources 422A and 422B coincides with the centroid G2 of the light receiving unit 16.

As illustrated in Fig. 9B, an irradiation region 430 of the light source unit 414 is larger than a light receiving region 440 of the light receiving unit 16 on the projection surface of the distance measuring apparatus 410. In the distance measuring apparatus 410, an irradiation region 432A of the light source 422A on one side in the X direction and an irradiation region 432B of the light source 422B on the other side in the X direction with respect to the light receiving unit 16 are disposed to overlap with each other on the center portion side of the light receiving unit 16. The irradiation regions 432A and 432B are examples of the different regions.

In the irradiation region 430, an overlapping portion 434 is formed by causing the irradiation regions 432A and 432B to overlap with each other.

Each of the irradiation regions 432A and 432B is configured with irradiation sections 438 corresponding to the plurality of light emitting sections 424. At least a part of all of the light emitting sections 424 falls within the light receiving region 440 of the light receiving unit 16. Other configurations of the distance measuring apparatus 410 of the fifth exemplary embodiment are the same as the configurations of the distance measuring apparatus 10 of the first exemplary embodiment and the distance measuring apparatus 210 of the third exemplary embodiment.

In the distance measuring apparatus 410 of the fifth exemplary embodiment, the same actions and effects are obtained by the same configurations as the configurations of the distance measuring apparatus 10 of the first exemplary embodiment and the distance measuring apparatus 210 of the third exemplary embodiment.

### [Sixth Exemplary Embodiment]

Next, a distance measuring apparatus according to a sixth exemplary embodiment will be described. Constituents identical to the first to fifth exemplary embodiments described above will be denoted by identical reference symbols and will not be described.

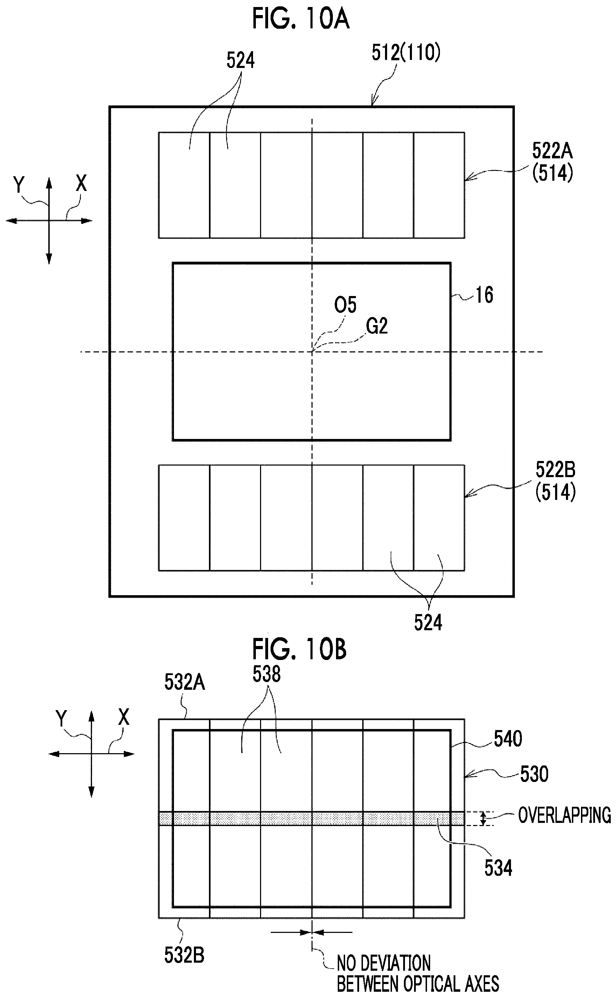

Fig. 10A is a configuration diagram illustrating an optical device 512 of a distance measuring apparatus 510 of the sixth exemplary embodiment, and Fig. 10B is a diagram illustrating a situation on a projection surface of the distance measuring apparatus 510 of the sixth exemplary embodiment.

As illustrated in Fig. 10A, in the distance measuring apparatus 510, a light source unit 514 includes two light sources 522A and 522B, and this point is different from the light source unit 14 of the distance measuring apparatus 10 of the first exemplary embodiment. In addition, in the distance measuring apparatus 510, light emitting sections 524 of the two light sources 522A and 522B have different shapes and disposition from the light emitting sections 424 of the light source unit 414 of the distance measuring apparatus 410 of the fifth exemplary embodiment.

In the distance measuring apparatus 510, the two light sources 522A and 522B are evenly disposed on both sides of the light receiving unit 16 in the Y direction. For example, the two light sources 522A and 522B are disposed on both sides of the light receiving unit 16 at the distance corresponding to the short side of the light receiving unit 16.

The light emitting sections 524 have rectangular shapes of which a length in the Y direction is longer than a length in the X direction. Each of the light sources 522A and 522B includes six light emitting sections 524. The light emitting sections 524 are disposed in six columns in the X direction. The light emitting sections 524 are disposed such that short sides of the light emitting sections 524 face each other with the light receiving unit 16 interposed among the light emitting sections 524.

In the distance measuring apparatus 510, a centroid O6 of the light source unit 514 including the two light sources 522A and 522B coincides with the centroid G2 of the light receiving unit 16.

As illustrated in Fig. 10B, an irradiation region 530 of the light source unit 514 is larger than a light receiving region 540 of the light receiving unit 16 on the projection surface of the distance measuring apparatus 510. In the distance measuring apparatus 510, an irradiation region 532A of the light source 522A on one side in the Y direction and an irradiation region 532B of the light source 522B on the other side in the Y direction with respect to the light receiving unit 16 are disposed to overlap with each other on the center portion side of the light receiving unit 16. The irradiation regions 532A and 532B are examples of the different regions.

In the irradiation region 530, an overlapping portion 534 is formed by causing the irradiation regions 532A and 532B to overlap with each other.

Each of the irradiation regions 532A and 532B is configured with irradiation sections 538 corresponding to the plurality of light emitting sections 524. Other configurations of the distance measuring apparatus 510 of the sixth exemplary embodiment are the same as the configurations of the distance measuring apparatus 10 of the first exemplary embodiment and the distance measuring apparatus 110 of the second exemplary embodiment.

In the distance measuring apparatus 510 of the sixth exemplary embodiment, the same actions and effects are obtained by the same configurations as the configurations of the distance measuring apparatus 10 of the first exemplary embodiment and the distance measuring apparatus 110 of the second exemplary embodiment.

### [Other]

While the present invention is described in detail with respect to specific exemplary embodiments, the present invention is not limited to such exemplary embodiments, and other various exemplary embodiments within the scope of the present invention will be apparent to those skilled in the art.

In the exemplary embodiments, the processes are performed by any computer. The computer may perform the processes by using a processor serving as hardware, a program serving as software, or combination of these. In this case, the processor is configured to perform the processes in the exemplary embodiments in cooperation with the program and may function as a unit or a means in the exemplary embodiments. The order in which the processor performs the processes is not limited to the described order and may be changed appropriately. The computer may be a general-purpose computer, an application specific computer, a workstation, or another system capable of performing the processes.

The processor may be composed of one or more pieces of hardware, and the type of the hardware is not limited. For example, the processor may be composed of hardware such as a central processing unit (CPU), a micro processing unit (MPU), a programmable logic device such as a field programmable gate array (FPGA), a dedicated circuit for performing specific processing such as an application specific integrated circuit (ASIC), a graphics processing unit (GPU), or a neural processing unit (NPU). Regarding the type of the hardware, different types of hardware may be combined. If multiple pieces of hardware are configured to perform one or more processes of the processor, the multiple pieces of hardware may be present in apparatuses physically away from each other or may be present in one apparatus. In each of exemplary embodiments, the order in which the processor performs the processes is not limited to the order described above and may be changed appropriately. The hardware is composed of electric circuitry in which circuit elements such as semiconductor devices are combined, or the like.

Further, the program may be software such as firmware or microcode. The program may be, for example, a program module group, and the functions thereof may be implemented by processors configured to implement the respective functions. The program may be program code or multiple code segments stored in one or more non-transitory computer readable media (for example, a storage medium or another storage). The program may be stored in such a divided manner in multiple non-transitory computer readable media present in apparatuses physically away from each other. The program code or the code segments may represent a procedure, a function, a sub program, a routine, a subroutine, a module, a software package, a class or any combination of instructions, data structures, or program statements. The program code or the code segment may be connected to another code segment or a hardware circuit by transmitting and/or receiving information, data, an argument, a parameter, or memory content.

The present invention is also applicable to a program and a program product.

### [Supplementary Note]

The following supplementary notes are further disclosed with respect to the above exemplary embodiments.
(((1))) A distance measuring apparatus comprising:
   a light source unit in which a plurality of light sources each including a plurality of divided light emitting sections are disposed, and the plurality of light sources irradiate different regions, respectively;
   a light receiving unit that receives reflected light of light emitted from the plurality of light sources to a detection target object; and
   a distance measuring unit that performs distance measuring of the detection target object in accordance with a waveform of the light received by the light receiving unit,
   wherein the plurality of light sources of the light source unit are disposed with the light receiving unit interposed among the plurality of light sources.
(((2))) The distance measuring apparatus according to (((1))),
   wherein a centroid of the light source unit coincides with a centroid of the light receiving unit.
(((3))) The distance measuring apparatus according to (((1))) or (((2))),
   wherein the disposition of the plurality of light sources of the light source unit is disposition in which a sum total of distances between the light sources and the light receiving unit is smaller than a sum total of distances among the plurality of light sources.
(((4))) The distance measuring apparatus according to any one of (((1))) to (((3))),
   wherein the number of light sources included in the light source unit is four or more, and
   the light sources are disposed with the light receiving unit interposed among the light sources in a first direction and are disposed with the light receiving unit not interposed among the light sources in a second direction orthogonal to the first direction.
(((5))) The distance measuring apparatus according to any one of (((1))) to (((4))),
   wherein the light emitting sections have rectangular shapes, and the light sources are disposed such that long sides of the light emitting sections face each other with the light receiving unit interposed among the light emitting sections, and
   an irradiation region of the light source on one side and an irradiation region of the light source on the other side with respect to the light receiving unit overlap with each other on a center portion side of the light receiving unit.
(((6))) The distance measuring apparatus according to (((5))),
   wherein one of the light emitting sections is turned off in a part in which the light emitting sections overlap with each other in the irradiation region.
(((7))) The distance measuring apparatus according to any one of (((1))) to (((4))),
   wherein the light emitting sections have rectangular shapes and are disposed such that short sides of the light emitting sections face each other with the light receiving unit interposed among the light emitting sections, and
   at least a part of all of the light emitting sections falls within a light receiving region of the light receiving unit.
(((8))) The distance measuring apparatus according to any one of (((1))) to (((7))),
   wherein the plurality of light sources are evenly disposed on both sides of the light receiving unit.
(((9))) The distance measuring apparatus according to any one of (((1))) to (((4))),
   wherein the light receiving unit has a rectangular shape, and
   the plurality of the light sources are disposed on both sides of the light receiving unit at a distance corresponding to a short side of the light receiving unit.
(((10))) The distance measuring apparatus according to (((9))),
   wherein the plurality of light sources are disposed along a long side of the light receiving unit.
(((11))) The distance measuring apparatus according to any one of (((1))) to (((4))),
   wherein the light receiving unit has a rectangular shape,
   the plurality of light sources are disposed on both sides of the light receiving unit at a distance corresponding to a long side of the light receiving unit, and
   the plurality of light sources are disposed along a short side of the light receiving unit.

According to the distance measuring apparatus according to (((1))), a decrease in the number of divided light emitting sections within an angle of view of the light receiving unit can be reduced compared to a case where a plurality of light sources each including a plurality of divided light emitting sections are collectively disposed on only one side of a light receiving unit.

According to the distance measuring apparatus according to (((2))), a decrease in the number of divided light emitting sections within the angle of view of the light receiving unit can be reduced compared to a case where a centroid of a light source unit is separated from a centroid of a light receiving unit.

According to the distance measuring apparatus according to (((3))), a decrease in the number of divided light emitting sections within the angle of view of the light receiving unit can be reduced compared to a case where disposition of a plurality of light sources is disposition in which a sum total of distances between the light sources and a light receiving unit is larger than a sum total of distances among the plurality of light sources.

According to the distance measuring apparatus according to (((4))), a decrease in the number of divided light emitting sections within the angle of view of the light receiving unit can be reduced in a configuration in which light sources are disposed with a light receiving unit interposed among the light sources in the first direction and are disposed with the light receiving unit not interposed among the light sources in the second direction orthogonal to the first direction.

According to the distance measuring apparatus according to (((5))), occurrence of an irradiation gap among the plurality of light sources in a center portion of the light receiving unit can be reduced compared to a case where light emitting sections closer to a light receiving unit do not overlap with each other in an irradiation region.

According to the distance measuring apparatus according to (((6))), power consumption can be reduced compared to a case where both of light emitting sections emit light in a part in which the light emitting sections overlap with each other in an irradiation region.

According to the distance measuring apparatus according to (((7))), a decrease in the number of divided light emitting sections within the angle of view of the light receiving unit can be reduced compared to a case where a part of light emitting sections does not fall within a light receiving region of a light receiving unit.

According to the distance measuring apparatus according to (((8))), a decrease in the number of divided light emitting sections within the angle of view of the light receiving unit can be reduced compared to a case where a plurality of light sources are disposed at different positions on both sides of a light receiving unit.

According to the distance measuring apparatus according to (((9))), the occurrence of the irradiation gap among the plurality of light sources in the center portion of the light receiving unit can be reduced compared to a case where a plurality of light sources are disposed on both sides of a light receiving unit at a distance corresponding to a long side of the light receiving unit.

According to the distance measuring apparatus according to (((10))), a decrease in the number of divided light emitting sections within the angle of view of the light receiving unit can be reduced compared to a case where one light source is disposed along a long side of a light receiving unit.

According to the distance measuring apparatus according to (((11))), a decrease in the number of divided light emitting sections within the angle of view of the light receiving unit can be reduced compared to a case where one light source is disposed along a short side of a light receiving unit.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

### Brief Description of the Reference Symbols

10: distance measuring apparatus
14: light source unit
16: light receiving unit
22A, 22B, 22C, 22D: light source
24: light emitting section
44: distance measuring unit
72A, 72B, 72C, 72D: irradiation region (example of different regions)
110: distance measuring apparatus
114: light source unit
122A, 122B, 122C, 122D: light source
124: light emitting section
132A, 132B, 132C, 132D: irradiation region (example of different regions)
210: distance measuring apparatus
214: light source unit
222A, 222B, 222C, 222D: light source
232A, 232B, 232C, 232D: irradiation region (example of different regions)
310: distance measuring apparatus
314: light source unit
322A, 322B, 322C, 322D, 322E, 322F: light source
324: light emitting section
332A, 332B, 332C, 332D, 332E, 332F: irradiation region (example of different regions)
410: distance measuring apparatus
414: light source unit
422A, 422B: light source
424: light emitting section
432A, 432B: irradiation region (example of different regions)
510: distance measuring apparatus
514: light source unit
522A, 522B: light source
524: light emitting section
532A, 532B: irradiation region
G2: centroid (example of centroid of light receiving unit)
O1: centroid (example of centroid of light source unit)
O2: centroid (example of centroid of light source unit)
O3: centroid (example of centroid of light source unit)
O4: centroid (example of centroid of light source unit)
O5: centroid (example of centroid of light source unit)
O6: centroid (example of centroid of light source unit)

## Claims

1. A distance measuring apparatus comprising:
a light source unit in which a plurality of light sources each including a plurality of divided light emitting sections are disposed, and the plurality of light sources irradiate different regions, respectively;
a light receiving unit that receives reflected light of light emitted from the plurality of light sources to a detection target object; and
a distance measuring unit that performs distance measuring of the detection target object in accordance with a waveform of the light received by the light receiving unit,
wherein the plurality of light sources of the light source unit are disposed with the light receiving unit interposed among the plurality of light sources.

2. The distance measuring apparatus according to claim 1,
wherein a centroid of the light source unit coincides with a centroid of the light receiving unit.

3. The distance measuring apparatus according to claim 1 or 2,
wherein the disposition of the plurality of light sources of the light source unit is disposition in which a sum total of distances between the light sources and the light receiving unit is smaller than a sum total of distances among the plurality of light sources.

4. The distance measuring apparatus according to any one of claims 1 to 3,
wherein the number of light sources included in the light source unit is four or more, and
the light sources are disposed with the light receiving unit interposed among the light sources in a first direction and are disposed with the light receiving unit not interposed among the light sources in a second direction orthogonal to the first direction.

5. The distance measuring apparatus according to any one of claims 1 to 4,
wherein the light emitting sections have rectangular shapes, and the light sources are disposed such that long sides of the light emitting sections face each other with the light receiving section interposed among the light emitting sections, and
an irradiation region of the light source on one side and an irradiation region of the light source on the other side with respect to the light receiving unit overlap with each other on a center portion side of the light receiving unit.

6. The distance measuring apparatus according to claim 5,
wherein one of the light emitting sections is turned off in a part in which the light emitting sections overlap with each other in the irradiation region.

7. The distance measuring apparatus according to any one of claims 1 to 4,
wherein the light emitting sections have rectangular shapes and are disposed such that short sides of the light emitting sections face each other with the light receiving unit interposed among the light emitting sections, and
at least a part of all of the light emitting sections falls within a light receiving region of the light receiving unit.

8. The distance measuring apparatus according to any one of claims 1 to 7,
wherein the plurality of light sources are evenly disposed on both sides of the light receiving unit.

9. The distance measuring apparatus according to any one of claims 1 to 4,
wherein the light receiving unit has a rectangular shape, and
the plurality of the light sources are disposed on both sides of the light receiving unit at a distance corresponding to a short side of the light receiving unit.

10. The distance measuring apparatus according to claim 9,
wherein the plurality of light sources are disposed along a long side of the light receiving unit.

11. The distance measuring apparatus according to any one of claims 1 to 4,
wherein the light receiving unit has a rectangular shape,
the plurality of light sources are disposed on both sides of the light receiving unit at a distance corresponding to a long side of the light receiving unit, and
the plurality of light sources are disposed along a short side of the light receiving unit.
